**Europäisches Patentamt**

**European Patent Office**

**Office européen des brevets**

(19)

(11) Publication number: **0 056 736**

**A1**

(12) # EUROPEAN PATENT APPLICATION

(21) Application number: **82300286.0**

(22) Date of filing: **20.01.82**

(51) Int. Cl.³: **B 26 D 7/01**
**B 26 F 1/32**

(30) Priority: **21.01.81 GB 8101747**

(43) Date of publication of application:
**28.07.82 Bulletin 82/30**

(84) Designated Contracting States:
**DE FR IT SE**

(71) Applicant: **Billows, Leonard Kay**
**1 Longdean Park**
**Hemel Hempstead Hertfordshire(GB)**

(72) Inventor: **Billows, Leonard Kay**
**1 Longdean Park**
**Hemel Hempstead Hertfordshire(GB)**

(74) Representative: **Barry, Patrick James et al,**
**ABEL & IMRAY Northumberland House 303-306 High**
**Holborn**
**London, WC1V 7LH(GB)**

(54) **Improvements in or relating to apparatus for positioning sheet material.**

(57) This invention relates to apparatus for positioning sheet material on a support table (40, 41), prior to making holes in the sheet material by punching. The apparatus comprises two positioning blocks (1, 2 means 7, 8, 9, 20, 21) linking the blocks for synchronous movement towards or away from a centre line between the blocks, a first block (2) being movable, independently of the second block (1), from an operative position in which the first block is engaged with a sheet to be positioned to an inoperative position in which the first block is not engaged with the sheet.

One or more further blocks can be provided, each movable in synchronism with the block (2) and movable independently of the block (1) in the same way as the block (2), so that the apparatus can provide, depending on which block is placed in its operative position, two or more different working centre-lines.

./...

Croydon Printing Company Ltd.

Fig.1.

Fig.2.

Improvements in or relating to apparatus for
positioning sheet material.

This invention relates to apparatus for positioning sheet material.

It is sometimes required to make holes in sheet
material and prior to making the holes the sheet material
must be in a particular position to ensure that the holes are
themselves correctly located on the sheet. For example, when
making holes in printing plates, films, paper and other sheet
material used in printing, graphic, arts, the manufacture of
printed circuit boards, map-making, drawing , art reproduction and in other industries, the sheet material must be so
located that the holes appear at required locations with
respect to the edges of the sheet material. In many cases,
two holes are required and these have to be equi-spaced from
the centre line of the sheet.

The sheet material is usually placed on a table
which supports the material in a position inclined to the
vertical. Along the lower edge of the table is a mechanism
for perforating the material usually in the form of hand or
power-operated punches. The material is placed on the table
with one edge abutting a stop or stops forming part of the
mechanism. The sheet is then centralised and the holes
punched.

The accurate location of the holes depends upon the
accuracy of centralisation and a number of devices have been
proposed for facilitating the centralisation of the sheet.

For example, the perforating mechanism may be
fitted with a linear scale that extends over the support
table. A block slidably mounted upon the scale can be clamped into a desired position along the scale depending upon the sheet size. Alternatively, the block may be fixed to the scale both being slidably mounted on the mechanism or on the table. After the block has been set to a required position, the sheet is placed with one edge abutting the stop or stops and an adjacent edge touching the block.

The position of the sliding block and/or scale is determined by a simple calculation. This technique requires only simple apparatus but for each different size of sheet a calculation is required and this and the accurate setting of the block and/or scale are sources of error.

Another form of positioning apparatus uses two movable stop blocks one on each side of the support table. The blocks are linked together so that when one block is moved the other moves by an equal amount in the opposite direction, i.e. both blocks move either towards or away from the centre line of the sheet material.

Because of the equal and opposite movements of the stop blocks no calculations are required but the blocks have to be moved away from a sheet after the latter has been perforated to allow the removal of the sheet from the support table and to allow space to load the next sheet. The blocks therefore have to be moved twice for each sheet and this is time consuming.

A further form of positioning apparatus has arms that extend sideways over the table from the punching apparatus. Several "fingers" are pivotally mounted upon each bar at different fixed axial positions thereon depending upon the range of sheet sizes that the apparatus is designed to accommodate. To position a particular size of sheet, the finger appropriate to that size is pivoted over into contact with the surface of the support table and the sheet is placed with one edge abutting the finger.

This further form of positioning apparatus is of simple construction and requires no calculations but it is possible for the sheet being positioned to slide between a finger and the table surface.

It is an object of the present invention to provide sheet positioning apparatus that is simple to operate is less subject to errors and less time consuming than previously proposed apparatus.

The present invention provides a positioning device comprising two positioning blocks, means linking the blocks for synchronous movement towards or away from a centre line between the blocks, one block (hereinafter referred to as the first block) being movable, independently of the other block (hereinafter referred to as the second block), from an operative position in which the first block is engaged with a sheet to be positioned to an inoperative position in which the first block is not engaged with the sheet.

A support may be provided having a surface for receiving a sheet to be positioned, each block being movable relative to the support.

The blocks may be slidably movable in a groove provided in the support.

Advantageously, when the first block is in its operative position, it provides a stop for the sheet which is proud of the support and when the first block is in its inoperative position, the stop is below or flush with that surface.

Advantageously, the first block is in two parts, one part being movable (preferably, tiltable) relative to the other, the said one part providing the stop.

Releasable locking means may be provided to retain the said one part in a respective one of two positions, one operative and the other inoperative, relative to the said other part.

The second block may have releasable means for clamping it in position relative to the support surface.

The device may be movable bodily relative to the support.

One or more further blocks may be provided, that block or blocks being identical to the first block, movable in synchronism with that block and being movable independently of the second block in the same way as the first block, the blocks being arranged in a row.

The linking means may comprise an endless chain to which the blocks are coupled to provide the synchronous movement.

The chain may be coupled to the blocks by linking strips of equal or different lengths.

Alternatively, the linking means may comprise a rack and pinion mechanism.

By way of example only, an embodiment of the invention will now be described in greater detail with reference to the accompanying drawings of which:-

Fig. 1  is a plan view of the embodiment,

Fig. 2  is a section on the line II-II of Fig. 1,

Fig. 3  is a view from underneath with a component removed,

Fig. 4  is a section on the line IV-IV of Fig. 2, and,

Fig. 5  is a section on the line V-V of Fig. 2.

The centering device comprises two positioning blocks 1, 2 slidable towards and away from each other in an elongate trough-shaped housing 3.

The blocks 1, 2 whose construction will be described in more detail below, are so coupled that they move along the housing 3 in synchronism.

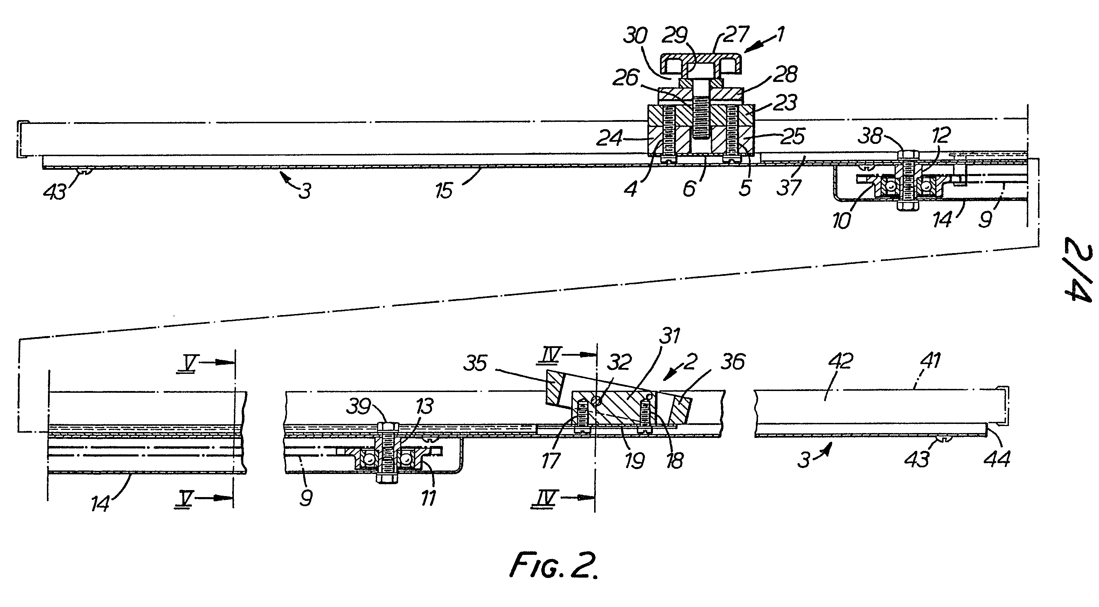

Secured to the undersurface of block 1 by screws 4, 5 is the square end portion 6 of a linking strip 7 whose other end is secured by a coupling 8 to a link of an endless chain 9 carried by sprocket wheels 10, 11 rotatably mounted upon stub shafts 12, 13 respectively located beneath the housing 3 as seen in Fig. 2, and protected by a removable cover 14. The floor 15 of the housing 3 is slotted as at 16 to accommodate the coupling 8.

Block 2 is coupled in a similar manner to the chain 9. Secured by screws 17, 18 to the undersurface of block 2 is the square end portion 19 of a linking strip 20 whose other end is secured to a link in the chain 9 by means of a coupling 21 which extends through a slot 22 in the floor 12 of the housing 3.

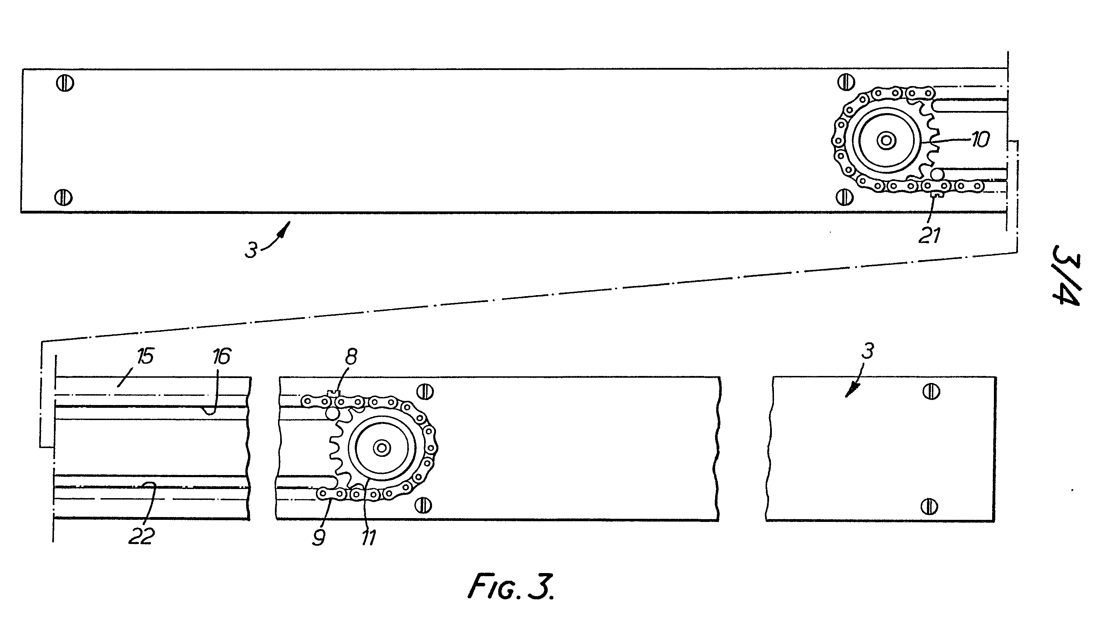

As can be seen from Fig. 3, the strips 7 and 20 are coupled to the chain 9 at opposite but corresponding points on the two runs of the chain 9 so that as the latter moves, the strips 7 and 20 move synchronously towards or away from each other and the blocks 1, 2 move in similar fashion. Movement of the couplings 8 and 21 is accommodated by the slots 16 and 22 respectively.

Positioning block 1 comprises a central support 23 into which screws 4 and 5 extend. Screws 4, 5 also secure mounting blocks 24, 25 respectively to the central support 23.

Screwed centrally into support block 23 is the threaded shaft 26 of an adjusting knob 27. Mounted upon a plane part of the shaft 26 is a bridging clamp 28 and interposed between the bridging clamp 28 and the central boss 29 on the knob 27 is a bearing washer 30.

The bridging clamp 28 is of inverted U-shape, the base of the U being of a length sufficient to bridge the central support 23 and to extend beyond the latter sufficiently to allow the ends of the limbs of the U to engage the edge portions bounding a groove 50 (referred to in detail below) in a support surface on which the sheet to be centralised is placed. Rotation of the knob 27 allows a user to raise and lower the bridging clamp 28 to release and clamp the positioning block 1 as will be described later.

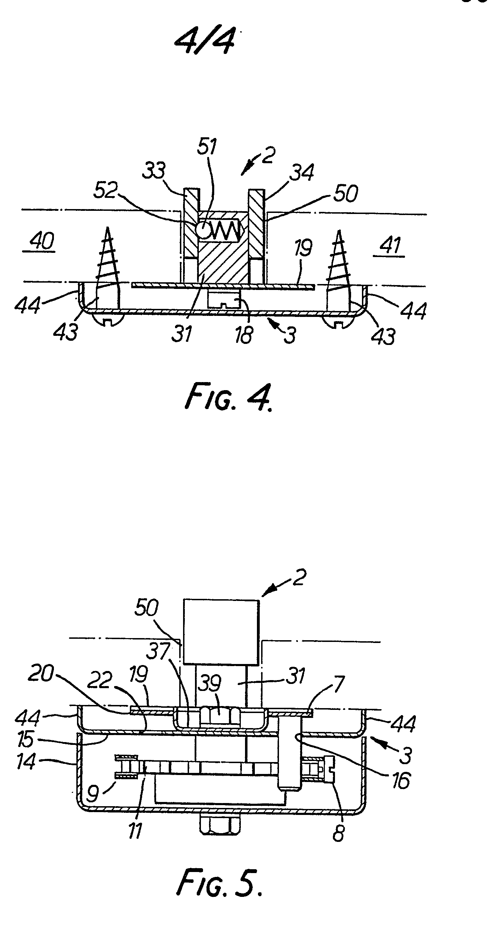

Positioning block 2 also has a central support and this is indicated at 31 in the drawings. Pivotally mounted

upon a pin 32 mounted in the support 31 is a/lever structure comprising side members 33, 34 with, at one end, an
integral cross member 35 and, at the other end, an integral
cross member 36. The lever structure is held in the position shown in Fig. 2 by a spring biassed ball catch 51
(see Fig. 4), the ball of which engages in a small dimple
52 in the inner face of side member 33. The right hand
(as seen in Fig. 2) ends of the side members 33, 34 and
the lower surface of cross member 36 are contoured to allow
this end of the lever structure to rest on end portion 19.

The lever structure can be pivoted from a first
orientation - that shown in Fig. 2 - to a second orientation in which the upper edges of the side members 33, 34
and the upper surface of the cross members 35, 36 are flush
or with or under the upper surface of the central support
31 by light downward pressure on the cross member 35 and
returned to the Fig. 2 position by light downward pressure
on the cross member 36.

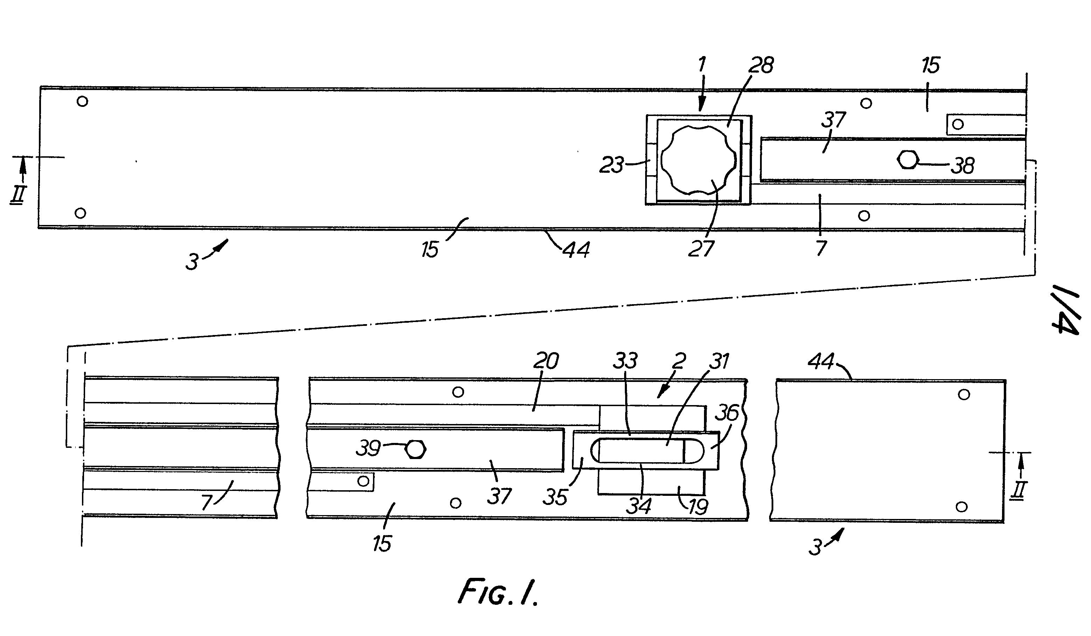

As can be seen from Fig. 1, the lever structure
occupies the centre portion only of the square end 19 of the
strip 20 leaving a substantial margin of the end 19 exposed
on each side of the block.

Over the central part of the floor 15 of the
housing 3 between the sprockets 10, 11 is a channel-shaped
strip 37 secured in place by bolts 38, 39 which also fix
the stub shafts 12, 13 to the floor 15. The strip 37 serves
to strengthen the central part of the floor 15 carrying the
sprockets 10, 11.

The positioning device may be used to centralise a sheet prior to punching holes in the latter and in this case the punch has a support surface on which the sheet is placed prior to punching and which, for the purpose of accommodating the positioning device, is in two parts separated by the narrow groove 50 beneath which the positioning device is located in a manner such that the positioning blocks 1 and 2 are positioned in the groove with the outer faces of the mounting blocks 24 and 25 and the side members 33 and 34 in sliding contact with the side walls of the groove. To facilitate sliding at least the outer surfaces of, but preferably the whole of, the blocks 24 and 25 are made of a suitable plastics material, for example nylon.

Figs. 4 and 5 show a part of each support surface, the parts being indicated at 40, 41. The edge 42 of part 41 is shown in Fig. 2.

The housing 3 is secured to the undersides of the support surfaces by means of screws some of which are shown in Figs. 2 and 4 and referenced 43. The housing 3 has an upturned flange 44 along each side and this engages the undersides when the housing is in position to provide clearance beneath the undersides for movement of the end portions 6 and 19 and the respective strips 7 and 20. The midpoint between the sprockets 10 and 11 lies on the centre line of two punches positioned at the edge of the support surface.

To use the positioning device a user, having first ensured that the lever structure is in the orientation shown in Fig. 2 (that is to say, in which part of the side member 35 projects above the upper side of the support surfaces) and that the blocks 1, 2 are spaced apart to a sufficient extent, places a sheet to be punched on the support surface between the blocks. Bridging clamp 28, if not already released, is released by rotation of knob 27 and using the latter the user then moves block 1 towards and into contact with the adjacent edge of the sheet. As block 1 is moved towards the sheet so does block 2 and, if necessary, the sheet to be positioned also moves. Eventually, both blocks 1, 2 are in contact (by virtue of the members 23 and 35) with respective opposite edges of the sheet and the latter is centralised with respect to the two punches. Bridging clamp 28 is then locked against the support surface by rotation of the knob 27 and the sheet punched.

The user then depresses cross member 36 bringing the lever structure into its orientation in which the upper surfaces of the side members 33, 34 and cross members 35, 36 are flush with or under the upper side of the support surfaces. The punched sheet is then easily removed and removal is unobstructed by the second block 2.

After the blocks 1, 2 have been centralised and the first sheet punched, a second sheet to be punched can now be placed on the support surface with the appropriate one of its edges in contact with block 1. It is not necessary to restore the lever structure of the second block to its orientation shown in Fig. 2 because the sheet to be punched can be centralised satisfactorily using only the first block 1.

The second sheet is then punched and removed.

It will be appreciated that the positioning device has the virtue of a single sliding block for positioning combined with the advantages of a self-centering device. It is not necessary to make any of the calculations and measurements associated with a conventional single sliding block system. Furthermore, it is not necessary to reposition the blocks after each punching operation.

The length of the strips 7, 20 determines the maximum distance apart of the blocks 1, 2 and thus the maximum width of sheet that can be accommodated by one set of strips. To permit use of the positioning device with a wide range of sheet sizes, extension strips are provided. These are bolted to the existing strips, using the holes provided for the screws 4, 5 and 17, 18, the respective blocks 1, 2 having first been removed. Such extension strips may have one or more than one position for the blocks.

The position of the device relative to the support surface can also be changed to allow alignment of the midpoint between the sprockets 10, 11 with different centre lines between differently-spaced punches.

Alternatively, the lengths of the strips 7, 20 could be different, and this can be achieved by adding to strip 20 extensions to which further blocks 2 are attached thus providing a single positioning device with different centre lines. Blocks 2 not in use will have their lever structures in the orientation in which the side members 33, 34 and cross members 35, 36 are flush with or under the upper side of the support surface.

Claims:

1. A positioning device comprising two positioning blocks, means linking the blocks for synchronous movement towards or away from a centre line between the blocks, one block (hereinafter referred to as the first block) being movable, independently of the other block (hereinafter referred to as the second block), from an operative position in which the first block is engaged with a sheet to be positioned to an inoperative position in which the first block is not engaged with the sheet.

2. A positioning device as claimed in claim 1, in which a support is provided having a surface for receiving a sheet to be positioned, each block being movable relative to the support.

3. A positioning device as claimed in claim 2, in which the blocks are slidably movable in a groove provided in the support.

4. A positioning device as claimed in claim 2 or claim 3, wherein, when the first block is in its operative position, it provides a stop for the sheet which is proud of the support and when the first block is in its inoperative position, the stop is below or flush with that surface.

5. A positioning device as claimed in claim 4, in which the first block is in two parts, one part being movable relative to the other, the said one part providing the stop.

6. A positioning device as claimed in claim 5, in which the said one part is tiltable relative to the other part.

7. A positioning device as claimed in claim 5 or claim 6, in which releasable locking means are provided to retain the said one part in a respective one of two positions, one operative and the other inoperative, relative to the said other part.

8. A positioning device as claimed in any one of claims 2 to 7, in which the second block has releasable means for clamping it in position relative to the support surface.

9. A positioning device as claimed in any one of claims 2 to 8, in which the device is movable bodily relative to the support.

10. A positioning device as claimed in any one of claims 1 to 9, wherein one or more further blocks are provided, that block or blocks being identical to the first block, movable in synchronism with that block and being movable independently of the second block in the same way as the first block, the blocks being arranged in a row.

11. A positioning device as claimed in any one of claims 1 to 10, in which the linking means comprises an endless chain to which the blocks are coupled to provide the synchronous movement.

12. A positioning device as claimed in claim 11, in which the chain is coupled to the blocks by linking strips of equal or different lengths.

FIG. I.

1/4

0056736

FIG. 2.

2/4

0056736

FIG. 3.

0056736

FIG. 4.

FIG. 5.

# EUROPEAN SEARCH REPORT

European Patent Office

Application number

EP 82 30 0286

| DOCUMENTS CONSIDERED TO BE RELEVANT | | | CLASSIFICATION OF THE APPLICATION (Int. Cl. ³) |
|---|---|---|---|
| Category | Citation of document with indication, where appropriate, of relevant passages | Relevant to claim | |
| | <u>US - A - 2 676 659</u> (EMMER) | | B 26 D 7/01<br>B 26 F 1/32 |
| X | * the whole document * | 1-7 | |
| Y | | 8-12 | |
| | -- | | |
| Y | <u>US - A - 2 482 218</u> (SEGAL) | | |
| | * the whole document * | 8,9 | |
| | -- | | |
| Y | <u>DE - U - 1 842 835</u> (KARL BARTSCH) | | TECHNICAL FIELDS SEARCHED (Int.Cl. ³) |
| | * page 3, line 24 - page 4, line 3; figure 4 * | 10 | B 26 D<br>B 26 F<br>G 03 F |
| | -- | | |
| Y | <u>DE - C - 536 443</u> (LÜLLAU) | | |
| | * the whole document * | 11,12 | |
| | -- | | |
| Y | <u>US - A - 2 587 185</u> (MARSH) | | |
| | * the whole document * | 10 | |
| | ------ | | |

CATEGORY OF CITED DOCUMENTS

X: particularly relevant if taken alone
Y: particularly relevant if combined with another document of the same category
A: technological background
O: non-written disclosure
P: intermediate document
T: theory or principle underlying the invention
E: earlier patent document, but published on, or after the filing date
D: document cited in the application
L: document cited for other reasons

&: member of the same patent family, corresponding document

The present search report has been drawn up for all claims

| Place of search | Date of completion of the search | Examiner |
|---|---|---|
| The Hague | 30-03-1982 | MEULEMANS |

EPO Form 1503.1 06.78